# EUROPEAN PATENT SPECIFICATION

(11) **EP 3 588 552 B1**
(45) Date of publication and mention of the grant of the patent: **28.04.2021**
(21) Application number: 19181121.5
(22) Date of filing: 19.06.2019
(51) Int. Cl.: H01L 23/34, H01L 23/42, H01L 23/373

(54) **THERMAL INTERFACE MATERIAL SHEET AND METHOD OF MANUFACTURING A THERMAL INTERFACE MATERIAL SHEET**
MATERIALFOLIE FÜR THERMISCHE SCHNITTSTELLE UND VERFAHREN ZUR HERSTELLUNG EINER MATERIALFOLIE FÜR THERMISCHE SCHNITTSTELLE
FEUILLE DE MATÉRIAU D'INTERFACE THERMIQUE ET PROCÉDÉ DE FABRICATION D'UNE FEUILLE DE MATÉRIAU D'INTERFACE THERMIQUE

(30) Priority: 21.06.2018 US 201816014684
(43) Date of publication of application: 01.01.2020
(73) Proprietor: ABB Schweiz AG, 5400 Baden (CH)
(72) Inventor: Manninen, Jorma, 00380 Helsinki (FI); Silvennoinen, Mika, 00380 Helsinki (FI); Koivuluoma, Timo, 00380 Helsinki (FI)
(74) Representative: Kolster Oy Ab

(56) References cited:
- EP-A1- 3 163 611
- US-A1- 2003 227 067

## Description

### FIELD OF THE INVENTION

The present invention relates generally to thermal interface materials.

### BACKGROUND OF THE INVENTION

Power electronic devices employ high power switches or power electronic modules which are able to switch high currents and withstand high voltages. The switched high currents generate heat losses inside the component or module, and these losses are led to a base plate of the component or module. A cooling device is further thermally connected to the base plate for transferring the heat from the component to the surroundings. A typical example of a cooling device is a heatsink which has a surface that can be thermally connected to the surface of the base plate. Some modules are manufacture without a base plate, but they still have a surface from which the heat is removed. The heat from the component is transferred to the heatsink which further transfers the generated heat to a cooling medium such as air or liquid to keep the temperature of the power electronic module in allowable values.

To test a performance of a cooling device, such as a heatsink, in connection with a power electronic module, information about module's chip temperature Tⱼ is required. The chip temperature refers to temperature of the semiconductor junction of the power electronic switch. It is challenging to measure the chip temperature directly and in practice it is estimated using a temperature reading from the module's baseplate directly under the chip of interest. This temperature is generally referred to as case temperature Tc. When the case temperature and the heat loss values are known, the chip temperature can be calculated using junction-to-case thermal resistance which is given by the component manufacturer. As a power electronic module has multiple of switch components, it is often required that the case temperature is measured in multiple of positions to obtain the temperature values of desired chips.

The existing methods for the measurement of the case temperature are laborious and expensive to arrange. In practice the known methods are suitable for maximum of only few (one to four) points' temperature monitoring although there may be over ten topical chips to monitor in a power electronic module. Therefore the existing methods are not feasible to apply into each manufactured product.

It is known to drill holes to the heatsink and to the base plate for placing a thermocouple in contact with the base plate. This approach may, however, damage the power electronic module. Further, the electrical wires may affect the module's electrical operation. This method is also not suitable with power electronic modules that do not have a base plate.

Another approach to measure case temperature is to use spring loaded thermocouples. These thermocouples are easy to use with air cooled heatsinks where through-holes are easy to drill to the heatsink. However their application becomes difficult with liquid and two-phase coolers where the coolant channel is often designed to run below the hottest chips i.e. where the sensor should be placed. The placement of the sensor is challenging into water cooled cold plates, base-to-air Cothex heat exchangers and heat pipe heatsinks. In such cooling devices some compromises need to be made over the sensor location in regard to the chip temperature of interest. The spring-loaded thermocouples provide accurate readings if the thermocouple is in direct contact with the base plate of the module. Thus when a thermal interface material is used between the heat generating component and the heatsink, the material should be paste or grease. If solid thermal interface materials are employed, the material should be removed from the places where measurement is made. Otherwise the thermal interface material affects the measurement.

Another issue with power electronic modules baseplate is the warping and bending of the baseplate during installation and use of the power electronic module. Especially if the use of the module or the device in which the module is situated is cyclic, the base plate may get out of its original shape. When the base plate is warped or bent, the transfer of heat from the module to the heatsink can be reduced such that the chip temperatures may rise to values which are not tolerable. The base plate's deviation from flatness may exceed 0.1 mm over the length of 50 mm during the use of the power electronic module. The deformation is mainly due to power cycling, temperature gradients and differences between thermal expansion coefficients. This dynamic behaviour causes complex deformation scenario to the thermal interface between the power electronic module and the heatsink. This deformation further may stress the thermal interface material between the power electronic module and the heatsink and may destroy the thermal interface material's capability to carry out the heat conduction function. In addition to the dynamic changes of the shape of the base plate, power electronic modules may also experience permanent deformation during operation. However, the bending and deformation of the base plate cannot be determined during use of the power electronic module.

Document US2003/227067A1 discloses a thin film measuring resistor formed as a planar component and arranged between an integrated circuit and a cooling body.

The above described problems relating to monitoring of temperature and deformation of the base plate may lead in destruction of the power electronic module as the chip temperatures may rise to levels which are not tolerable.

### BRIEF DISCLOSURE OF THE INVENTION

An object of the present invention is thus to provide a structure and a method of manufacturing the structure so as to overcome the above problems. The objects of the invention are achieved by a thermal interface material sheet and a method of manufacturing such sheet which are characterized by what is stated in the independent claims. The preferred embodiments of the invention are disclosed in the dependent claims.

The invention is based on the idea of providing thin film sensors in the structure of thermal interface material sheet. Thermal interface materials are placed between the heat generating component and the cooling device to enhance the transfer of heat from the component to the cooling device. Once a sensor is disposed in the thermal interface material sheet and the thermal interface material is between the heat generating component and the cooling device, it can be used to measure accurately a property, such as temperature or pressure, of the assembly.

The thin film sensor is a physical vapour deposition (PVD) grown thin film sensor and the thermal interface material (TIM) sheet is preferably a carbon based sheet. The TIM sheet is partially coated with an electrically insulating layer to facilitate sensor manufacturing using PVD method.

The thin film sensor is preferably a resistor based temperature sensor, piezo resistive strain gauge to measure pressure or a piezo resistive sensor for sensing both the temperature and pressure.

The TIM-sheet of the present disclosure operates as a thermal interface material sheet for electronic components, such as power electronic modules, and at the same time is able to produce measurement data from the interconnection between the electronic component and the cooling element without affecting the transfer of heat.

### BRIEF DESCRIPTION OF THE DRAWINGS

In the following the invention will be described in greater detail by means of preferred embodiments with reference to the accompanying drawings, in which
Figure 1 illustrates the placement of a TIM sheet with thin film sensors;
Figure 2 and 3 show schematic constructions of a TIM sheet with a sensor;
Figure 4 shows a schematic construction of a TIM sheet with multiple of sensors;
Figure 5 shows a schematic construction of a TIM sheet with PVD grown thin film sensor; and
Figure 6 shows a schematic view of a TIM sheet with PVD grown thin film sensor.

### DETAILED DESCRIPTION OF THE INVENTION

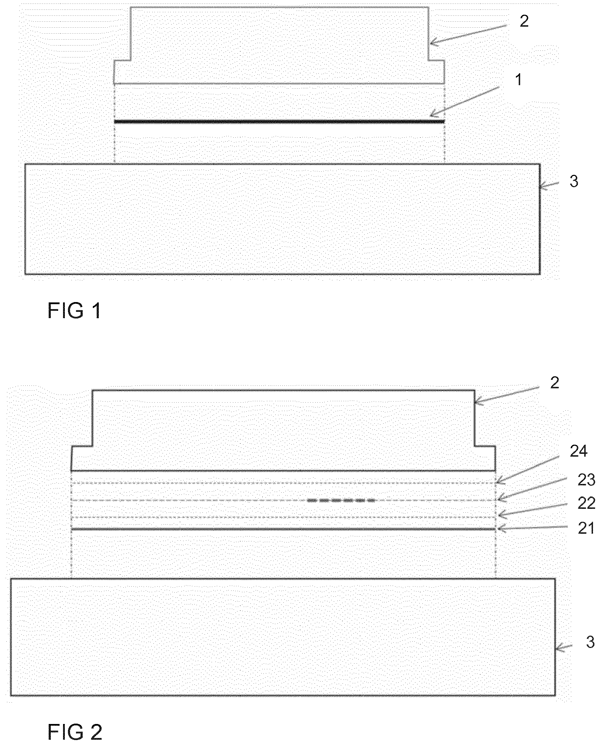

Figure 1 shows the thermal interface material sheet 1 of the present disclosure in connection with a power electronic module 2 and a cooling device 3, such as a heat sink. The components of Figure 1 are shown separated from each other. However, it is clear that the power electric module 2 is attached tightly to the cooling device 3 with the thermal interface material between the module and the cooling device.

Figure 2 shows a structure of the invention with different layers of the sheet separated from each other. According to the invention, the thermal interface material sheet comprises a carbon based layer, such as a graphite or graphene sheet 21. The carbon based layer 21 is at least partially coated with electrically insulating layer 22. Examples of such electrically insulating layer include PET film or PVD ceramics. The thin film sensor 23 is grown on top of the insulating layer using PVD method, and a second electrically insulating layer 24 is placed on top of the sensor 23. When the PVD grown sensor is a thin film strain sensor, it is beneficial to attach the TIM sheet firmly to the base surface of the power electronic module or similar heat generating component to achieve a higher measurement accuracy. Therefore the second insulating layer 24 may have an adhesive coating on the surface facing the base surface of the power electronic module.

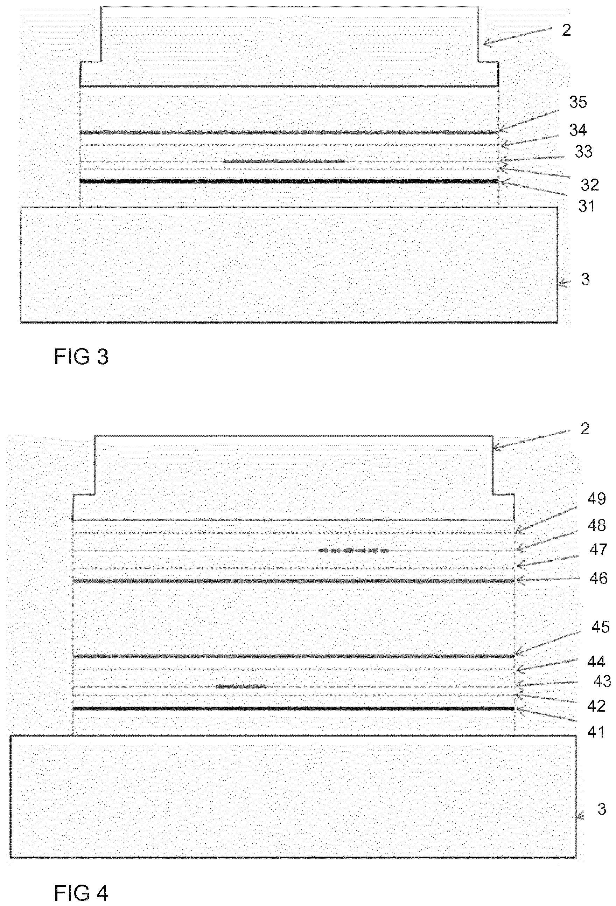

Figure 3 shows another embodiment of the invention with a temperature sensor in the TIM sheet. The thermal interface material sheet of the example consists of a carbon based layer 31, which is at least partly covered with electrically insulating layer 32 on top of which a resistive temperature sensor 33 is grown with a PVD method. On top of the resistive temperature sensor is a second electrically insulating layer 34, which covers at least the sensor. The structure of the thermal interface material layer of the example of Figure 3 comprises also a lubricating top layer 35 which provides wear resistance to the structure. The lubricating layer may be achieved with a carbon based material, for example.

Figure 4 shows another embodiment of the invention in which both a temperature sensor and a strain sensor are employed. The structure of the thermal interface material sheet of Figure 4 is basically combination of the sheets of Figures 2 and 3. In Figure 4 a carbon based thermal interface material layer 41 is provided. On top of the TIM layer 41 is disposed an electrically insulating layer 42 which covers the TIM layer at least partially. The insulating layer 42 has a PVD grown temperature sensor 43 which is covered with a second insulating layer 44. On top of the insulating layer is a carbon based material layer 45 for providing lubrication and wear resistance.

Figure 4 further shows a strain sensor assembly which is formed of a carbon based material sheet 46, electrically insulating layer 47 on top of which a strain gauge 48 is grown with PVD method. The uppermost layer is an electric insulating layer 49, such as a PET film with an adhesive on the surface facing the base of the heat generating component 2. The carbon based material sheet 46 is an optional layer as it is on top of a similar carbon based sheet 45.

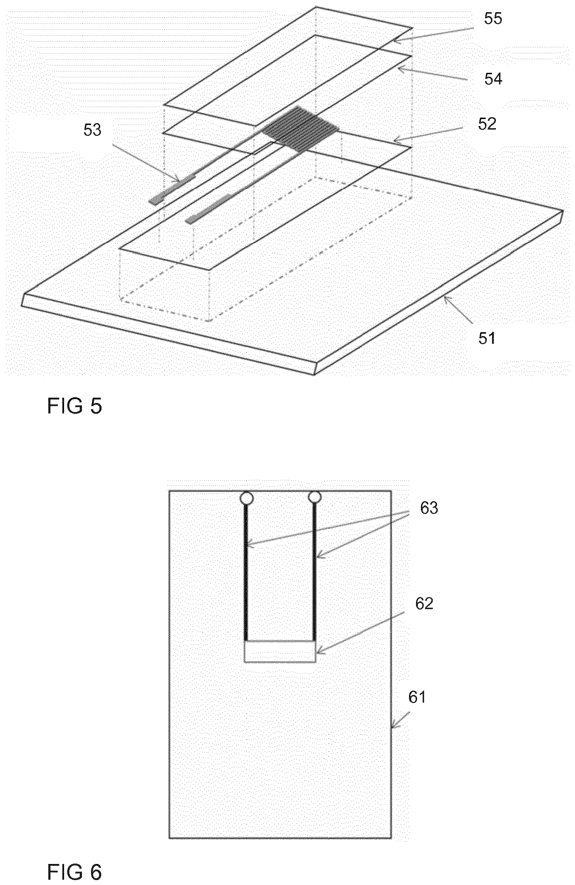

Figure 5 shows another view of an embodiment of the present invention for better understanding the invention. A graphite sheet 51 is provided and an electrically insulating layer 52 is set on top of the graphite sheet 51. The electrically insulating layer is not covering the graphite sheet 51 completely as the purpose of the insulating layer is to be a base for the PVD grown sensor 53. A second electrically insulating layer 54 is placed on top of the sensor 53, and a wear resistant layer 55 is provided on top of the second insulating layer. As can be seen from Figure 5, the graphite sheet or layer 51 has a surface area that is larger than the surface areas of the other layers. The other layers are provided in order to enable manufacturing of the sensor and to protect the sensor, and therefore the layers are dimensioned such that the surface area of the layers is covering the sensor. It should be noted, that base plate of the component or module may be formed of electrically insulating material, such as ceramic material. When the base plate is electrically insulating, the insulating layer on top of the graphite sheet is not required. Further, the surface of the cooling device may also be coated with an electrically insulating material, which also reduces the need of insulating layers in the thermal interface material sheet. The coating may be a ceramic coating or anodised coating when the cooling device is of aluminium.

Figure 6 shows a different view of a simplified structure of the invention with the sensor and its electrical connectors visible. The structure shows a planar view of a carbon based material layer 61, a sensor 62 and the electrical conductors of the sensor.

The electrical conductors needed for the sensor are also manufactured on the insulating layer with the same technology as the sensor. The sensor is an electrical component and the electrical properties of the component are changed due to change of temperature or pressure depending on the type of sensor. When the sensor is connected as a part of an electrical circuit using the electrical conductors, the information obtained with the sensors is readily available in other circuits. For example, the temperature and pressure information can be used in real time when the device employing the structure of the invention is used. Based on the temperature and the pressure information the condition of the cooling of the device may be monitored. If the measurements show that a measured temperature is rising above a set limit, an alarm may be given and the device may be turned off in a controlled manner. Similarly the strain sensor in the thermal interface material layer may be used for providing indication of changed conditions. If the pressure between the cooling device and the base of the power electronic module decreases, it is an indication of a change that will affect the cooling properties.

In the shown embodiments only one sensor is disposed on one layer. However, multiple of sensors can be manufactured on the same electrically insulating layer. The sensors may be of the same or different type. This, for example, enables to measure temperature in different locations under the base of the power electronic module. Further, multiple of sensors in one layer enables to simplify the construction as the number of different layers is minimized.

The thermal interface material layer of the invention acts as a normal thermal interface and can be used in connection with any type of cooling device. The cooling device does not need any modifications for measurement of temperature or pressure. The thermal interface material layer is preferably made of 70 to 200 µm thick carbon layer and the insulating layer on top of the carbon layer is, for example 10 µm thick PET film or PVD ceramics layer.

The PVD manufacturing method is known as such, and the manufacturing of the sensors using PVD method is not specifically described here. In the above the PVD method is used as an example of a suitable method for producing thin film sensors. Included in the PVD technologies, the low temperature PVD technology is the most suitable for growing thin film sensors and conductors on an electrically insulating polyimide films. Other suitable method or technologies include chemical vapour deposition (CVD) and ink-jet technology.

In the above the thermal interface material is described to be carbon based material, such as graphite. Although graphite may be a preferred material, the material can also be a thin metal sheet, multilayer thermally conducting silicone rubber or aluminium sheet structure. Generally the requirement for the thermal interface material is that it is solid enough to support the thin film structure disposed in the thermal interface material sheet of the invention.

In the drawings the structure of the invention is shown as separate layers. However, it is clear that a single sheet is formed of the separate layers. Further the sensors are illustrated as separate layers in the attached drawings. The sensors are however grown on the insulating layer and are therefore one single structure.

Figures 2 and 3 are used in the following to illustrate the method of manufacturing a thermal interface material sheet. In the method, a thermal interface material layer 21 is provided. A thin film sensor 23, such as a resistive sensor or a strain gauge sensor is disposed on an electrically insulating 22 layer. The thin film sensor is grown on the electrically insulating film or layer usig PVD method which known as such. Further in the method, a second electrically insulating layer 24 is disposed on top of the sensor for producing a thermal interface material sheet. According to an embodiment of the method, the second electrically insulating layer is provided with an adhesive layer. According to another embodiment, a lubricating layer is disposed on top of the second electrically insulating layer to provide wear resistance.

The invention relates also to an electrical device, such as an inverter or a frequency converter, which comprises one or more power electronic modules. The electronic device of the invention comprises a cooling device, such as a heat sink thermally connected to a power electronic module. A thermal interface material sheet of the invention is disposed between the cooling device and the power electronic module. Further, the electrical connectors of the thermal interface material layer are electrically connected to the electrical circuitry of the electronic device for obtaining information relating to the operation of the cooling device.

It will be obvious to a person skilled in the art that, as the technology advances, the inventive concept can be implemented in various ways. The invention and its embodiments are not limited to the examples described above but may vary within the scope of the claims.

## Claims

1. A thermal interface material sheet (1) to be disposed between a heat generating electrical component (2) and a cooling device (3), the thermal interface material sheet comprising at least one thin film sensor (23) and electrical conductors connected to the at least one thin film sensor for measuring a property related to the heat generating electrical component, **characterized in that** the at least one thin film sensor (23) is physical vapour deposition (PVD) grown sensor.

2. The thermal interface material sheet according to claim 1, wherein the electrical conductors are physical vapour deposition grown conductors.

3. The thermal interface material sheet according to claim 1, wherein the thermal interface material sheet comprises a thermal interface material layer, an electrically insulating layer (22) on which the at least one thin film sensor (23) is disposed, and a second electrically insulating layer (24) on top of the at least one thin film sensor.

4. The thermal interface material sheet according to claim 3, wherein the second electrically insulating layer comprises an adhesive on the top of the layer for attachment to a base of the heat generating electrical component.

5. The thermal interface material sheet according to claim 3, wherein the thermal interface material sheet further comprises a lubricating layer on top of the second electrically insulating layer for providing wear resistance.

6. The thermal interface material sheet according to claim 4, wherein the thermal interface material layer is a carbon based layer, a thin metal sheet thermal interface layer or a multilayer thermally conducting silicone rubber layer.

7. The thermal interface material sheet according to claim 6, wherein the thermal interface material layer has a larger surface area than the insulating layers.

8. A thermal interface material sheet according to claim 3, wherein the sensor is a temperature sensor or a strain gauge sensor.

9. A method of manufacturing a thermal interface material sheet, the method comprising providing a thermal interface material layer, providing an electrically insulating layer (22), disposing on the electrically insulating layer at least one thin film sensor (23), and providing a second electrically insulating layer (24) on top of the at least one thin film sensor, **characterized in that** the at least one thin film sensor is physical vapour deposition (PVD) grown sensor.

10. The method according to claim 9, wherein the method comprises further providing an adhesive layer on top of the second electrically insulating layer.

11. The method according to claim 9, wherein the method comprises further providing a lubricating layer on top of the second electrically insulating layer.

12. An electrical device comprising a power electronic module (2) and a cooling device (3), wherein a thermal interface material sheet having at least one thin film sensor (23) and electrical conductors connected to the at least one thin film sensor for measuring a property related to the heat generating electrical component is disposed between a base of the power electronic module and the cooling device, and the electrical conductors are connected to the electrical circuitry of the electrical device, **characterized in that** the at least one thin film sensor is physical vapour deposition (PVD) grown sensor.

13. The electrical device according to claim 12, wherein the electrical device is a frequency converter or an inverter.

14. The thermal interface material sheet according to claim 5, wherein the thermal interface material layer is a carbon based layer, a thin metal sheet thermal interface layer or a multilayer thermally conducting silicone rubber layer.

15. The thermal interface material sheet according to claim 14, wherein the thermal interface material layer has a larger surface area than the insulating layers.

## Patentansprüche

1. Materialfolie für thermische Schnittstelle (1), die zwischen einer wärmeerzeugenden elektrischen Komponente (2) und einer Kühlvorrichtung (3) angeordnet werden soll, wobei die Materialfolie für thermische Schnittstelle mindestens einen Dünnfilmsensor (23) und elektrische Leiter umfasst, die mit dem mindestens einen Dünnfilmsensor verbunden sind, um eine Eigenschaft zu messen, die mit der wärmeerzeugenden elektrischen Komponente zusammenhängt, **dadurch gekennzeichnet, dass** der mindestens eine Dünnfilmsensor (23) ein durch physikalische Gasphasenabscheidung (PVD) gezüchteter Sensor ist.

2. Materialfolie für thermische Schnittstelle nach Anspruch 1, wobei die elektrischen Leiter durch physikalische Gasphasenabscheidung gezüchtete Leiter sind.

3. Materialfolie für thermische Schnittstelle nach Anspruch 1, wobei die Materialfolie für thermische Schnittstelle eine Materialschicht für thermische Schnittstelle, eine elektrisch isolierende Schicht (22), auf welcher der mindestens eine Dünnfilmsensor (23) angeordnet ist, und eine zweite elektrisch isolierende Schicht (24) oben auf dem mindestens einen Dünnfilmsensor umfasst.

4. Materialfolie für thermische Schnittstelle nach Anspruch 3, wobei die zweite elektrisch isolierende Schicht einen Klebstoff oben auf der Schicht zur Befestigung an einer Basis der wärmeerzeugenden elektrischen Komponente umfasst.

5. Materialfolie für thermische Schnittstelle nach Anspruch 3, wobei die Materialfolie für thermische Schnittstelle des Weiteren eine Schmierschicht oben auf der zweiten elektrisch isolierenden Schicht umfasst, um Verschleißfestigkeit bereitzustellen.

6. Materialfolie für thermische Schnittstelle nach Anspruch 4, wobei die Materialschicht für thermische Schnittstelle eine Schicht auf Kohlebasis, eine thermische Schnittstellenschicht aus dünnem Metallblech oder eine mehrschichtige wärmeleitende Silikonkautschukschicht ist.

7. Materialfolie für thermische Schnittstelle nach Anspruch 6, wobei die Materialschicht für thermische Schnittstelle einen größeren Flächeninhalt als die Isolierschichten aufweist.

8. Materialfolie für thermische Schnittstelle nach Anspruch 3, wobei der Sensor ein Temperatursensor oder Dehnungsmessstreifensensor ist.

9. Verfahren zum Fertigen einer Materialfolie für thermische Schnittstelle, wobei das Verfahren Bereitstellen einer Materialschicht für thermische Schnittstelle, Bereitstellen einer elektrisch isolierenden Schicht (22), Anordnen von mindestens einem Dünnfilmsensor (23) auf der elektrisch isolierenden Schicht und Bereitstellen einer zweiten elektrisch isolierenden Schicht (24) oben auf dem mindestens einen Dünnfilmsensor umfasst, **dadurch gekennzeichnet, dass** der mindestens eine Dünnfilmsensor ein durch physikalische Gasphasenabscheidung (PVD) gezüchteter Sensor ist.

10. Verfahren nach Anspruch 9, wobei das Verfahren des Weiteren Bereitstellen einer Klebstoffschicht oben auf der zweiten elektrisch isolierenden Schicht umfasst.

11. Verfahren nach Anspruch 9, wobei das Verfahren des Weiteren Bereitstellen einer Schmierstoffschicht oben auf der zweiten elektrisch isolierenden Schicht umfasst.

12. Elektrische Vorrichtung, umfassend ein Leistungselektronikmodul (2) und eine Kühlvorrichtung (3), wobei eine Materialfolie für thermische Schnittstelle mit mindestens einem Dünnfilmsensor (23) und elektrischen Leitern, die mit dem mindestens einen Dünnfilmsensor verbunden sind, um eine Eigenschaft zu messen, die mit der wärmeerzeugenden elektrischen Komponente zusammenhängt, zwischen einer Basis des Leistungselektronikmoduls und der Kühlvorrichtung angeordnet ist und die elektrischen Leiter mit dem elektrischen Schaltkreis/den elektrischen Schaltkreisen der elektrischen Vorrichtung verbunden ist bzw. sind, **dadurch gekennzeichnet, dass** der mindestens eine Dünnfilmsensor ein durch physikalische Gasphasenabscheidung (PVD) gezüchteter Sensor ist.

13. Elektrische Vorrichtung nach Anspruch 12, wobei die elektrische Vorrichtung ein Frequenzumrichter oder ein Wechselrichter ist.

14. Materialfolie für thermische Schnittstelle nach Anspruch 5, wobei die Materialschicht für thermische Schnittstelle eine Schicht auf Kohlebasis, eine thermische Schnittstellenschicht aus dünnem Metallblech oder eine mehrschichtige wärmeleitende Silikonkautschukschicht ist.

15. Materialfolie für thermische Schnittstelle nach Anspruch 14, wobei die Materialschicht für thermische Schnittstelle einen größeren Flächeninhalt als die Isolierschichten aufweist.

## Revendications

1. Feuille de matériau d'interface thermique (1) devant être disposée entre un composant électrique générant de la chaleur (2) et un dispositif de refroidissement (3), la feuille de matériau d'interface thermique comprenant au moins un capteur en couche mince (23) et des conducteurs électriques reliés à l'au moins un capteur en couche mince pour mesurer une propriété associée au composant électrique générant de la chaleur, **caractérisé en ce que** l'au moins un capteur en couche mince (23) est un capteur élaboré par dépôt physique en phase vapeur (PVD).

2. Feuille de matériau d'interface thermique selon la revendication 1, dans laquelle les conducteurs électriques sont des conducteurs élaborés par dépôt physique en phase vapeur.

3. Feuille de matériau d'interface thermique selon la revendication 1, la feuille de matériau d'interface thermique comprenant une couche de matériau d'interface thermique, une couche électriquement isolante (22) sur laquelle est disposé l'au moins un capteur en couche mince (23), et une deuxième couche électriquement isolante (24) au-dessus de l'au moins un capteur en couche mince.

4. Feuille de matériau d'interface thermique selon la revendication 3, dans laquelle la deuxième couche électriquement isolante comprend un adhésif au-dessus de la couche pour fixation à une base du composant électrique générant de la chaleur.

5. Feuille de matériau d'interface thermique selon la revendication 3, la feuille de matériau d'interface thermique comprenant en outre une couche lubrifiante au-dessus de la deuxième couche électriquement isolante pour apporter une résistance à l'usure.

6. Feuille de matériau d'interface thermique selon la revendication 4, dans laquelle la couche de matériau d'interface thermique est une couche à base de carbone, une couche d'interface thermique en fine tôle métallique ou une couche de caoutchouc de silicone thermoconductrice multicouche.

7. Feuille de matériau d'interface thermique selon la revendication 6, dans laquelle la couche de matériau d'interface thermique a une plus grande superficie que les couches isolantes.

8. Feuille de matériau d'interface thermique selon la revendication 3, dans laquelle le capteur est un capteur de température ou une jauge de contrainte.

9. Procédé de fabrication d'une feuille de matériau d'interface thermique, le procédé comprenant l'obtention d'une couche de matériau d'interface thermique, l'application d'une couche électriquement isolante (22), la disposition sur la couche électriquement isolante d'au moins un capteur en couche mince (23), et l'application d'une deuxième couche électriquement isolante (24) au-dessus de l'au moins un capteur en couche mince, **caractérisé en ce que** l'au moins un capteur en couche mince est un capteur élaboré par dépôt physique en phase vapeur (PVD).

10. Procédé selon la revendication 9, le procédé comprenant en outre l'application d'une couche adhésive au-dessus de la deuxième couche électriquement isolante.

11. Procédé selon la revendication 9, le procédé comprenant en outre l'application d'une couche lubrifiante au-dessus de la deuxième couche électriquement isolante.

12. Dispositif électrique comprenant un module électronique de puissance (2) et un dispositif de refroidissement (3), dans lequel une feuille de matériau d'interface thermique ayant au moins un capteur en couche mince (23) et des conducteurs électriques reliés à l'au moins un capteur en couche mince pour mesurer une propriété associée au composant électrique générant de la chaleur est disposée entre une base du module électronique de puissance et le dispositif de refroidissement, et les conducteurs électriques sont reliés au circuit électrique du dispositif électrique, **caractérisé en ce que** l'au moins un capteur en couche mince est un capteur élaboré par dépôt physique en phase vapeur (PVD).

13. Dispositif électrique selon la revendication 12, le dispositif électrique étant un convertisseur de fréquence ou un onduleur.

14. Feuille de matériau d'interface thermique selon la revendication 5, dans laquelle la couche de matériau d'interface thermique est une couche à base de carbone, une couche d'interface thermique en fine tôle métallique ou une couche de caoutchouc de silicone thermoconductrice multicouche.

15. Feuille de matériau d'interface thermique selon la revendication 14, dans laquelle la couche de matériau d'interface thermique a une plus grande superficie que les couches isolantes.
